Europäisches Patentamt

European Patent Office

Office européen des brevets

(11) Veröffentlichungsnummer: **0 492 335 A2**

## EUROPÄISCHE PATENTANMELDUNG

(21) Anmeldenummer: **91121512.7**

(51) Int. Cl.5: **B29C 59/16**

(22) Anmeldetag: **16.12.91**

(30) Priorität: **27.12.90 DE 4041884**

(43) Veröffentlichungstag der Anmeldung:
**01.07.92 Patentblatt 92/27**

(84) Benannte Vertragsstaaten:
**CH DE FR GB IT LI NL**

(71) Anmelder: **ABB PATENT GmbH**
**Kallstadter Strasse 1**
**W-6800 Mannheim 1(DE)**

(72) Erfinder: **Esrom, Hilmar, Dr.**
**Auf der Höhe 6**
**W-6803 Edingen-Neckarhausen(DE)**
Erfinder: **Kogelschatz, Ulrich, Dr.**
**Obere Parkstrasse 8**
**CH-5212 Hausen bei Brugg(CH)**

(74) Vertreter: **Rupprecht, Klaus, Dipl.-Ing. et al**
**c/o ABB Patent GmbH, Patentabteilung,**
**Postfach 10 03 51**
**W-6800 Mannheim 1(DE)**

(54) **Verfahren zur Behandlung von Oberflächen.**

(57) Die Erfindung bezieht sich auf ein Verfahren zum Abtragen oder partiellen Strukturieren der Oberfläche (1S) eines Substrats (1) aus einem Polymer. Erfindungsgemäß wird die Oberfläche (1S) des Substrats mit einer inkohärenten UV-Strahlung bestrahlt, die eine Wellenlänge von 60 nm bis 400 nm aufweist. Zur Ausbildung der Strukturen wird eine Maske (4) auf die Oberfläche (1S) des Substrats (1) aufgelegt.

Fig.2

EP 0 492 335 A2

Rank Xerox (UK) Business Services

Die Erfindung bezieht sich auf ein Verfahren zur Strukturierung von Oberflächen von Substraten aus Polymeren mit einer Lichtquelle.

Für eine Reihe von Anwendungen auf den Gebieten der Elektronik, Leiterplatten- Multilayer- und Halbleitertechnik sowie der Optoelektronik sind organische Polymere von großer Bedeutung. Die Polymere, die für diese Techniken von besonderer Bedeutung sind, haben eine ausgezeichnete chemische Stabilität. Substrate aus diesen Polymeren, die für die Anwendung in dieser Technologie auf ihren Oberflächen mit einer Strukturierung versehen werden müssen, können nur mit erheblichem Aufwand die erforderliche Oberflächenbehandlung erhalten.

Aus der US-PS 4,857,382 sind ein Verfahren und eine Vorrichtung zum photochemischen Ätzen von Polymeren in Form von Polyimiden, Polyamiden und Polycarbonaten beschrieben. Hierfür wird eine Lichtquelle in Form einer Quecksilberlampe verwendet, die kontinuierliches UV-Licht aussendet. Weniger als 10 % dieser UV-Strahlung weist eine Wellenlänge kleiner 200 nm auf. Hierdurch ist nur eine sehr kleine Materialabtragungsrate möglich. Komplexe geometrische Strukturen können auf der Oberfläche mit dieser Lichtquelle nicht ausgebildet werden. Da ein erheblicher Strahlungsanteil im Infrarotbereich liegt, ist eine Zusätzliche Kühlung der Einrichtung und des Substrats erforderlich, was die Vorrichtung und das Verfahren wiederum erschwert und verteuert.

Der Erfindung liegt die Aufgabe zugrunde, ein Verfahren aufzuzeigen, mit dem die Strukturierung von Oberflächen von Substraten aus Polymeren leichter und kostengünstiger durchgeführt werden kann.

Diese Aufgabe wird durch die Merkmale des Patentanspruches 1 gelöst.

Erfindungsgemäß wird die Oberfläche eines Substrats aus einem Polymer, die vollständig oder partiell abgetragen werden soll, mit UV-Licht bestrahlt, das vorzugsweise einen Wellenlänge zwischen 60 und 340 nm aufweist. Bei der Strukturierung von Oberflächen von Substraten, die aus Polyimid oder Polycarbonat gefertigt sind, werden vorzugsweise eine UV-Strahlung mit einer Wellenlänge von 172 nm verwendet. Als Strahlungsquelle wird ein UV-Hochleistungsstrahler, nachfolgend auch kurz Excimerstrahler, verwendet. Mit diesem Strahler kann die gesamte Substratfläche bestrahlt werden. Erfindungsgemäß besteht die Möglichkeit, anstelle eines Strahlers auch mehrere Strahler zu verwenden. Mit Erhöhung der UV-Leistung der Excimerstrahler kann die Abtragrate erheblich gesteigert werden.

Weitere erfindungswesentliche Merkmale sind in den Unteransprüchen gekennzeichnet.

Die Erfindung wird nachfolgend anhand von schematischen Zeichnungen näher erläutert.

Es zeigen:

Fig. 1    die Behandlung einer Substratoberfläche,

Fig. 2    das durch die Behandlung gemäß Fig. 1 hergestellte Substrat.

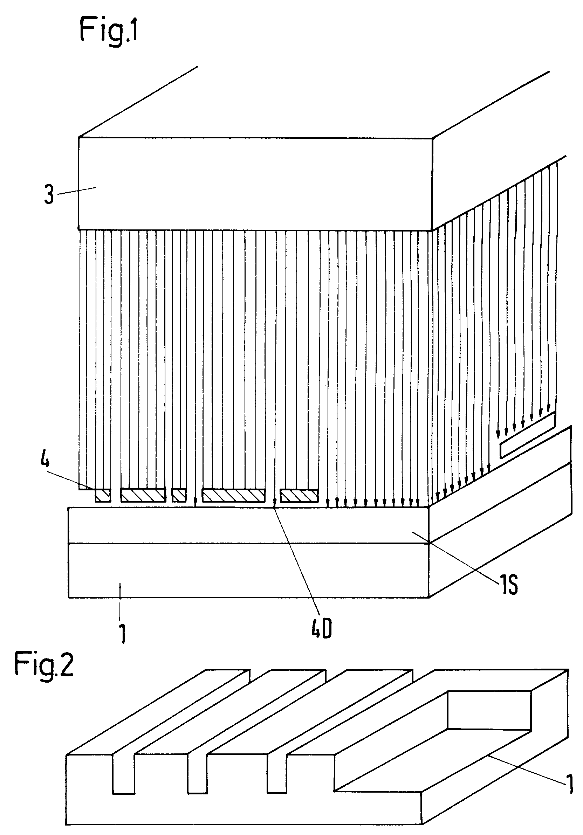

Fig. 1 zeigt ein flächiges Substrat 1, mit einem rechteckigen Querschnitt, das aus einem Polymer gefertigt ist. Es wird davon ausgegangen, daß es sich bei dem Polymer um Polyimid handelt. Substrate aus Polycarbonat können ebenfalls so behandelt werden. In definiertem Abstand von der Oberfläche 1S des Substrats 1 ist ein Excimerstrahler 3 angeordnet. Dieser ist in Fig. 1 nur schematisch dargestellt. Eine detaillierte Beschreibung eines solchen Excimerstrahlers 3 kann der EP-OS 0 254-111 entnommen werden. Der Excimerstrahler 3 besteht aus einem durch eine einseitig gekühlte Metallelektrode (hier nicht dargestellt) und ein Dielektrikum oder durch zwei Dielektrika- (hier ebenfalls nicht dargestellt) begrenzten und mit einem Edelgas oder Gasgemisch gefüllten Entladungsraum (hier nicht dargestellt). Das Dielektrikum und die auf der dem Entladungsraum abgewandten Oberfläche des Dielektrikums liegende zweite Elektrode sind für die durch stille elektrische Entladung erzeugte Strahlung transparent. Durch diese Konstruktion und durch eine geeignete Wahl der Gasfüllung wird ein großflächiger UV-Hochleistungsstrahler 3 mit hohem Wirkungsgrad geschaffen. Mit Hilfe der jeweiligen Gasfüllung kann UV-Strahlung mit einem Wellenlängenbereich zwischen 60 und 400 nm erzeugt werden. Das wichtigste Merkmale dieses Entladungstyps ist die Existenz einer dielektrischen Barriere, also eines Isolators im Strompfad zwischen den Elektroden. Da dieser Isolator keinen Gleichstrom durchläßt, kann die Entladung nur mit Wechselstrom betrieben werden. Dabei speist der dielektrische Verschiebungsstrom die Entladung oder anders ausgedrückt, bewirkt das Dielektrikum eine kapazitive Kopplung zwischen der treibenden elektrischen Quelle und dem Entladungsplasma. Wird die stille Entladung bei einem Druck oberhalb von ca. 0,1 bar betrieben, so bildet sich sehr viele dünne Stromfäden aus. Diese Mikroentladungen bestehen jeweils aus einer annähernd zylindrischen Plasmasäule und münden beim Übergang auf das Dielektrikum in eine Oberflächenentladung.

Die UV-Strahlung wird durch Excimerbildung in den Mikroentladungen erzeugt.

Soll nun beispielsweise das aus Polyimid hergestellte Substrat 1 mit einer Oberflächenstruktur versehen werden, so wird, wie in Fig. 1 dargestellt, auf die Oberfläche des Substrats 1 eine Maske 4 aufgelegt. Diese ist mit Durchlässen 4D versehen. Durch diese Durchlässe 4D kann das von dem Excimerstrahler 3 kommende Licht auf die Oberfläche des Substrates 1 gelangen. Es hat sich gezeigt, daß durch Verwendung von UV-Strahlung mit einer Wellenlänge von 172 nm ein Abätzen des Polymers möglich ist. Um mit Hilfe des Hochleistungsstrahlers 3 eine solche UV-Strahlung erzeugen zu können, erhält dieser eine Gasfüllung aus Xenon. Die Xenonentladung führt durch Elektronenstoß zur Bildung angeregter Xenonatome Xe* und im Anschluß daran zur Excimerbildung.

In der Entladung laufen zusätzliche Reaktionen zwischen weiteren angeregten Reaktionspartnern Xe**, $Xe_2$** sowie positiven Ionen $Xe^+$, $Xe_2^+$ und Elektronen ab. Die gebildeten $Xe_2$*-Excimere zerfallen innerhalb weniger Nanosekunden und geben ihrer Bindungsenergie in Form von UV-Strahlung ab. Der Hochleistungsstrahler 3 wird mit einer Wechselspannung gespeist, deren Frequenz zwischen 50 Hz und 1 MHz liegt, und deren Amplitude einige Kilovolt beträgt. Durch geeignete Wahl des Fülldrucks und der Emtladungsparameter entsteht ein Spektrum, in dem nur das zweite Kontinuum des $Xe_2$* - Excimers erscheint. Es handelt sich um eine relativ schmalbandige Emmision, deren Maximum bei 172 nm im Vakuumultraviolett liegt und deren Halbwertsbreite etwa 12 nm beträgt. Diese Strahlung entspricht einer Photonenenergie von 7.2 eV und ist damit energetisch in der Lage, diverse chemische Molekülverbindungen direkt zu spalten. Zu diesen Molekülverbindungen gehören auch die von Polyimid, aus dem das Substrat 1 hergestellt ist. Die mit dem Hochleistungsstrahler erreichbaren Photonenflüsse liegen bei $10^{16}$ bis $10^{17}$ Photonen pro Sekunde und pro $cm^2$ Elektrodenfläche (Größenordnung: 100 mW/cm$^2$). Durch Vergrößerung der Elektrodenfläche oder durch die Parallelschaltung mehrerer solcher Hochleistungsstrahler lassen sich sehr hohe UV-Leistungen erzielen. Die Oberfläche 1S des in Fig. 1 dargestellten Substrats 1 wird nun durch die Maske 4 mit einem solchen Hochleistungsstrahler 3, der UV-Strahlung mit einer Wellenlänge von 172 nm aussendet, bestrahlt. Es entstant nach einer Belichtungszeit von 30 Minuten, wobei die ganze Anordnung im Vakuum angeordnet ist, das in Fig. 2 dargestellte Substrat, mit der gezeigten Oberflächenstrukturierung. Im Bereich der Durchlässe 4D ist die Oberflächenschicht 1S bis zu einer Tiefe von 1.5 $\mu$m abgeätzt. Die von der Maske 2 geschützten Flächen sind nicht abgeätzt. Erfindungsgemäß besteht die Möglichkeit, mit Hilfe des Hochleistungsstrahlers 3 auch die gesamte Oberfläche 1S des Substrates 1 um 1,5 $\mu$m abzutragen. Hierfür wird auf die Anordnung der Maske 4 vollständig verzichtet, so daß eine ganzflächige Bestrahlung möglich ist. In gleicher Weise können Substrate 1 aus Polycarbonat mit einer strukturierten Oberfläche 1S versehen werden.

**Patentansprüche**

1. Verfahren zum Abtragen und/oder Strukturieren von Oberflächen (1S) von Substraten (1) aus Polymeren durch Bestrahlen mit einer Lichtquelle, dadurch gekennzeichnet, daß die Oberfläche (1S) des Substrats (1) partiell oder vollständig der Einwirkung von UV-Photonen mit einer Wellenlänge zwischen 60 nm bis 400 nm ausgesetzt wird.

2. Verfahren nach Anspruch 1, dadurch gekennzeichnet, daß zur vollständigen Abtragung oder partiellen Strukturierung die Oberfläche (1S) des Substrats (1) mit einem Hochleistungsstrahler (3) bestrahlt wird, der UV-Strahlung mit einer Wellenlänge zwischen 60 nm und 400 nm erzeugt.

3. Verfahren nach einem der Ansprüche 1 oder 2, dadurch gekennzeichnet, daß die Oberfläche (1S) eines Substrats aus Polyimid, Polyamid oder Polycarbonat partiell oder vollständig der Einwirkung von UV-Photonen mit einer Wellenlänge von 172 nm ausgesetzt wird.

4. Verfahren nach einem der Ansprüche 1 bis 3, dadurch gekennzeichnet, daß zur Abtragung oder partiellen Strukturierung die Oberfläche (1S) eines Substrats (1) aus Polyimid, Polyamid oder Polycarbonat mit UV-Strahlung bestrahlt wird, die eine Wellenlänge von 172 nm aufweist und vom einem Hochleistungsstrahler (3) erzeugt wird, der eine Xenongasfüllung aufweist.

5. Verfahren nach einem der Ansprüche 1 bis 4, dadurch gekennzeichnet, daß zur vollständigen Abtragung oder Strukturierung der Oberfläche (1S) eine Substrats aus Polyimid, Polyamid oder Polycarbonat die Oberfläche (1S) mit UV-Strahlung der Wellenlänge 172 nm 1 bis 30 Minuten lang im Vakuum bestrahlt wird.

## Fig.1

3

4

40

1

1S

## Fig.2

1